# EUROPEAN PATENT APPLICATION

(11) **EP 3 933 385 A1**
(43) Date of publication of application: **05.01.2022**
(21) Application number: 20762362.0
(22) Date of filing: 26.02.2020
(51) Int. Cl.: G01N 21/84, F21V 23/00, F21Y 103/10, F21Y 115/10, H01L 33/50, F21S 2/00, F21V 9/38, F21V 9/40, F21W 131/40

(54) **ILLUMINATING SYSTEM, ILLUMINATING DEVICE, AND ILLUMINATION CONTROL METHOD**

(30) Priority: 27.02.2019 JP 2019034774
(71) Applicant: Kyocera Corporation, Kyoto-shi, Kyoto 612-8501 (JP)
(72) Inventor: KATOU, Hidetaka, Kyoto-shi, Kyoto 612-8501 (JP); IKEDA, Kohei, Kyoto-shi, Kyoto 612-8501 (JP); YAMAMOTO, Kazutaka, Kyoto-shi, Kyoto 612-8501 (JP); KIMOTO, Noritane, Kyoto-shi, Kyoto 612-8501 (JP)
(74) Representative: Viering, Jentschura & Partner mbB Patent- und Rechtsanwälte
(86) International application number: PCT/JP2020/007854
(87) International publication number: WO 2020/175576

(57) **Abstract**

An illuminating system includes an illuminating device that emits inspection light with which an inspection target is illuminated, an information acquiring device that acquires information regarding the inspection target, and a control device that controls the inspection light on the basis of the information regarding the inspection target.

## Description

### Cross-Reference to Related Application

The present application claims priority to Japanese Patent Application No. 2019-34774 (filed on February 27, 2019), the disclosure of which is incorporated herein by reference in its entirety.

### Technical Field

The present disclosure relates to an illuminating system, an illuminating device, and an illumination control method.

### Background Art

For a visual inspection, a configuration that facilitates detection of an external appearance defect on a painted surface is known (see, for example, PTL 1).

### Citation List

### Patent Literature

PTL 1: Japanese Unexamined Patent Application Publication No. 2016-142525

### Summary of Invention

An illuminating system according to one embodiment of the present disclosure includes an illuminating device, an information acquiring device, and a control device. The illuminating device emits first inspection light with which an inspection target is illuminated. The information acquiring device acquires information regarding the inspection target. The control device controls the first inspection light on the basis of the information regarding the inspection target.

An illuminating device according to one embodiment of the present disclosure includes a light emitting device, an information acquiring unit, and a control unit. The light emitting device emits light included in inspection light with which an inspection target is illuminated. The control unit controls the light included in the inspection light on the basis of information regarding the inspection target.

An illumination control method according to one embodiment of the present disclosure includes an emitting step of emitting first inspection light with which an inspection target is illuminated, an information acquiring step of acquiring information regarding the inspection target, and a control step of controlling the first inspection light on the basis of the information regarding the inspection target.

### Brief Description of Drawings

[Fig. 1] Fig. 1 is a block diagram illustrating an example configuration of an illuminating system according to one embodiment.
[Fig. 2] Fig. 2 is a perspective view illustrating an example configuration of an illuminating device including light emitting devices.
[Fig. 3] Fig. 3 is a perspective view illustrating an example external appearance of the illuminating device.
[Fig. 4] Fig. 4 is a plan view illustrating an example external appearance of the illuminating device.
[Fig. 5] Fig. 5 is a diagram illustrating an example of light-dark illumination.
[Fig. 6] Fig. 6 is a schematic diagram illustrating an example inspection target having a surface that reflects light-dark illumination.
[Fig. 7] Fig. 7 is an external perspective view illustrating an example configuration of the light emitting device.
[Fig. 8] Fig. 8 is a cross-sectional view cut along A-A in Fig. 7.
[Fig. 9] Fig. 9 is an enlarged view of a circled part in Fig. 8.
[Fig. 10] Fig. 10 is a graph showing a spectrum of violet light.
[Fig. 11] Fig. 11 is a graph showing spectra of blue fluorescence, blue-green fluorescence, green fluorescence, and red fluorescence.
[Fig. 12] Fig. 12 is a graph showing a spectrum of near-infrared fluorescence.
[Fig. 13] Fig. 13 is a flowchart illustrating an example procedure for controlling the illuminating device.
[Fig. 14] Fig. 14 is a block diagram illustrating an example configuration of the illuminating device according to another embodiment.

### Description of Embodiments

Inspectors visually inspect the external appearances of various inspection targets. There is a demand for increasing inspection accuracy for various inspection targets.

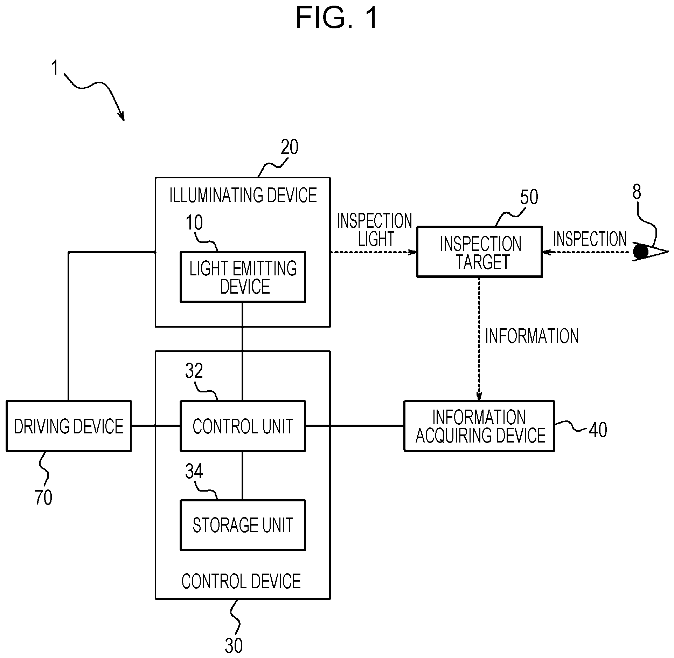

An illuminating system 1 and an illuminating device 20 (see Fig. 1) according to one embodiment of the present disclosure can increase inspection accuracy for various inspection targets.

As illustrated in Fig. 1, the illuminating system 1 according to one embodiment includes the illuminating device 20 that illuminates an inspection target 50 with light, a control device 30 that controls the illuminating device 20, and an information acquiring device 40 that acquires information from the inspection target 50. The illuminating device 20 includes a light emitting device 10 that emits light. Light with which the inspection target 50 is illuminated is also called inspection light. Hereinafter, inspection light with which the illuminating device 20 illuminates the inspection target 50 is also called first inspection light. Light emitted from the light emitting device 10 is also called second inspection light. At this time, the first inspection light and the second inspection light may be the same or may be different. The first inspection light includes at least the second inspection light. Light emitted through a light emitting surface of a light guiding member 22 described below is third inspection light. The third inspection light may be the same as the first inspection light and/or the second inspection light or may be different from the first inspection light and/or the second inspection light. The first inspection light includes at least the third inspection light, and the third inspection light includes at least the second inspection light.

It is assumed that the illuminating system 1 according to this embodiment is installed in a production line for industrial products, each of which is the inspection target 50, for an inspection process. The inspection target 50 may be, for example, a vehicle, such as an automobile, or an aircraft. The inspection target 50 may be a painted surface of, for example, a vehicle or an aircraft. The inspection target 50 may be the interior of, for example, a vehicle or an aircraft. The inspection target 50 may be furniture, such as a sofa or a table. The inspection target 50 is not limited to the above-described examples and may include various industrial products. The illuminating system 1 need not be installed for an inspection process for industrial products and may be installed for an inspection process for various products including, for example, agricultural products, such as vegetables, or dairy products, such as cheese.

In the inspection process for which the illuminating system 1 according to this embodiment is installed, an inspector 8 visually inspects the external appearance of the inspection target 50 illuminated by the illuminating device 20. The inspector 8 may detect a flaw or deformation including irregularities present on the surface of the inspection target 50 as an external appearance defect. The inspector 8 may detect a foreign matter, such as waste or dust, adhered to the surface of the inspection target 50 as an external appearance defect. The inspector 8 may detect for example, the color shade of the surface of the inspection target 50 different from a sample color shade as an external appearance defect. The inspector 8 may detect external appearance defects in various forms in addition to the above-described examples. It is desirable that the illuminating system 1 illuminate the inspection target 50 with inspection light that allows the inspector 8 to easily detect external appearance defects in the inspection target 50.

In a visual inspection, a phenomenon called glare may occur in which, for example, inspection light reflected by the surface of the inspection target 50 directly enters the eyes of the inspector 8, and the inspector 8 is dazzled. The glare may make the inspector 8 uncomfortable, impair the vision of the inspector 8, or accelerate eye strain of the inspector 8 and may cause difficulty in detecting an external appearance defect. As a result, the glare decreases the quality of the visual inspection. Therefore, illumination with inspection light with which glare is less likely to occur is desirable.

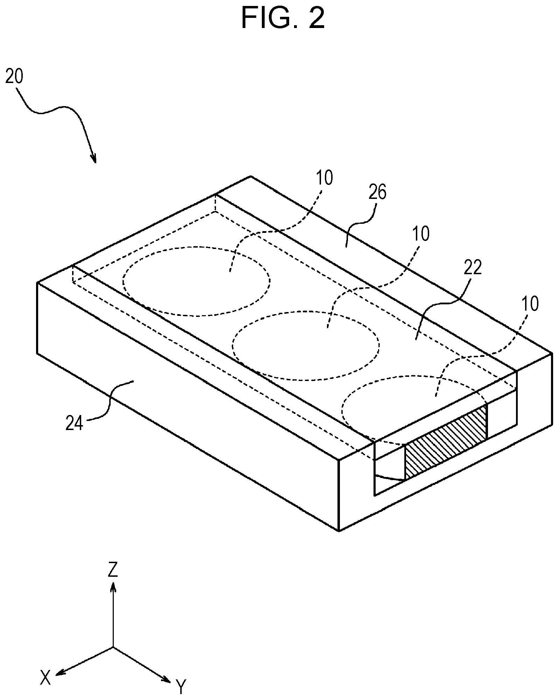

As illustrated in Fig. 2, the illuminating device 20 includes the light emitting devices 10, the light guiding member 22, and a casing 24. The casing 24 includes a peripheral part 26. The light emitting devices 10 are mounted in the casing 24 and covered by the light guiding member 22. The light emitting devices 10 are, for example, arranged in a line in the Y-axis direction. The light emitting devices 10 may be arranged in a plurality of lines. The light emitting devices 10 may be arranged in the form of a grid, such as a square grid or a rhombic grid. The light emitting devices 10 need not be arranged as in the above-described examples and may be arranged in various forms. It is assumed that the light guiding member 22 is in the form of a board. The light guiding member 22 having a board form is also called a light guiding board. The light guiding member 22 has a first board surface that faces the outer side of the illuminating device 20 and a second board surface that faces the inner side of the illuminating device 20 and faces the light emitting devices 10. A surface of each light emitting device 10 through which light is emitted may be in contact with the second board surface. In a case where the surface of each light emitting device 10 through which light is emitted is in contact with the second board surface, the ratio of light that propagates through the light guiding member 22 to light emitted from the light emitting device 10 is higher than that in a case where the surface of each light emitting device 10 through which light is emitted is not in contact with the second board surface.

Each light emitting device 10 emits light (second inspection light) in the positive direction of the Z axis. The light emitted from the light emitting device 10 enters the second board surface of the light guiding member 22. The light guiding member 22 transmits the entering light along the first board surface and the second board surface and emits the light as inspection light (third inspection light) in a direction crossing the first board surface. The first board surface through which the second inspection light is emitted as the third inspection light is also called a light emitting surface. The third inspection light that is emitted through the light emitting surface has a substantially uniform intensity within the surface. When the third inspection light is emitted through the light emitting surface, the illuminating device 20 is regarded as a surface light source that emits light in a planar form.

The peripheral part 26 is located on the edge of the light guiding member 22 (outside the outer edge). The peripheral part 26 may partially cover the edge of the light emitting surface of the light guiding member 22. The peripheral part 26 does not allow light to be emitted therethrough. In a case where the peripheral part 26 partially covers the edge of the light emitting surface of the light guiding member 22, the peripheral part 26 blocks or reduces light emitted through the light emitting surface. An image formed as a result of planar light emitted by the illuminating device 20 being reflected on the inspection target 50 is high in contrast on the boundary between the light emitting surface and the peripheral part 26. The light emitting surface is a flat surface extending to the boundary with the peripheral part 26, and therefore, contrast on the boundary is further made higher. As a comparative example, a configuration is possible where a tubular fluorescent lamp is covered by a flat diffusion cover. In this case, the fluorescent lamp has a tubular form, and therefore, it is difficult to make the light emitting surface be a flat surface. Accordingly, the intensity of light in the edge part of the diffusion cover is likely to become low. In the illuminating device 20 according to this embodiment, light having a substantially uniform intensity can be emitted through the light emitting surface including the boundary with the peripheral part 26. As a result, contrast on the boundary between the light emitting surface and the peripheral part 26 can be made higher than that in the configuration of the comparative example. The surface of the peripheral part 26 may be formed of a black material or, for example, an antireflection film having a low reflectivity. When the reflectivity of the surface of the peripheral part 26 is low, contrast on the boundary between the light emitting surface and the peripheral part 26 can be further made higher.

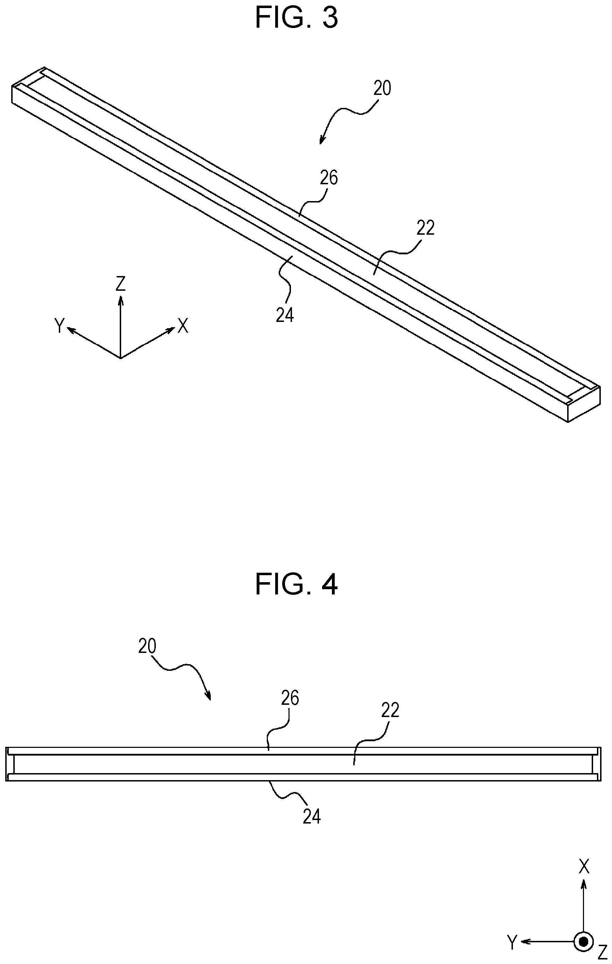

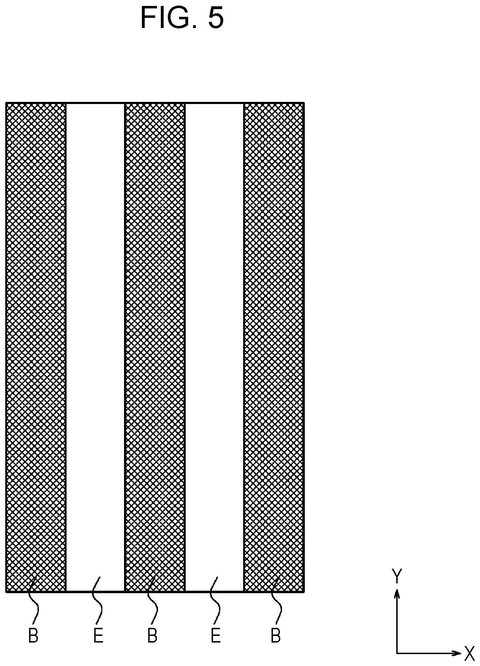

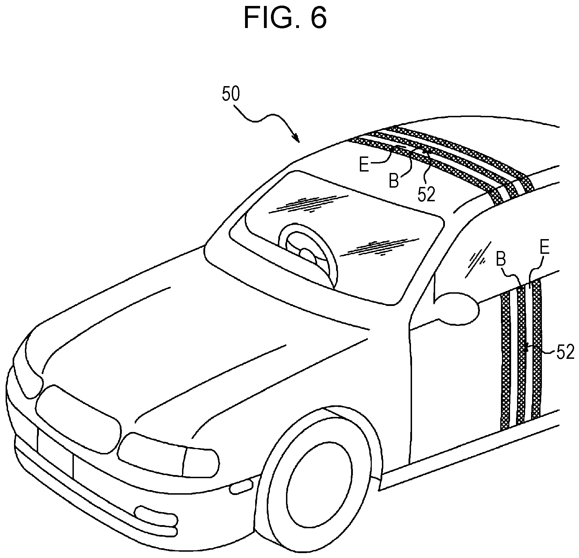

The illuminating device 20 may have an external appearance illustrated in, for example, Fig. 3 and Fig. 4. It is assumed that the light guiding member 22 has a rectangular shape having a lengthwise direction and a widthwise direction when viewed from the first board surface. In this case, the illuminating device 20 can emit rectangular planar light. The lengthwise direction and the widthwise direction correspond to the Y-axis direction and the X-axis direction respectively. The illuminating system 1 may include a plurality of illuminating devices 20. The illuminating devices 20 may be arranged in the widthwise direction of the light guiding member 22. When the plurality of illuminating devices 20 are arranged in the widthwise direction of the light guiding member 22, illumination in which light emitting regions E and non-light emitting regions B are arranged in the form of stripes is formed as illustrated in, for example, Fig. 5. The illumination in which the light emitting regions E and the non-light emitting regions B are arranged in the form of stripes is also called light-dark illumination. For example, in a case where the inspection target 50 is an automobile, the light emitting regions E and the non-light emitting regions B of light-dark illumination are reflected on the surface of the body of the automobile as illustrated in Fig. 6.

As illustrated in Fig. 1, the control device 30 includes a control unit 32 and a storage unit 34. The control unit 32 outputs control instructions to the constituent units of the illuminating system 1 and acquires various type of information from the constituent units. For example, the control unit 32 controls the spectrum and intensity of light emitted by the light emitting device 10 as the second inspection light. The light emitting device 10 can emit light rays identified with various spectra as described below. The control unit 32 may include at least one processor in order to provide control and a processing capacity for executing various functions. The processor can execute a program for implementing various functions of the control unit 32. The processor may be implemented as a single integrated circuit. The integrated circuit is also called an IC. The processor may be implemented as a plurality of integrated circuits and discrete circuits that are communicably connected to each other. The processor may be implemented on the basis of other various known techniques.

The control unit 32 may include an interface. The control unit 32 may be communicably connected to the constituent units of the illuminating system 1 by wire or wirelessly via the interface. The interface may include a communication interface for, for example, a LAN (local area network). The interface may implement communication conforming to any of the various communication methods, such as 4G (4th Generation) or 5G (5th Generation), or LTE (Long Term Evolution). The interface may include a communication interface for contactless communication, such as infrared communication or NFC (Near-Field Communication). The interface may include a port via which signals based on a serial communication standard, such as RS232C or RS485, can be input and output.

The storage unit 34 may include an electromagnetic storage medium, such as a magnetic disk, or may include a memory, such as a semiconductor memory or a magnetic memory. The storage unit 34 stores, for example, various types of information and the program executed by the control unit 32. The storage unit 34 may function as a work memory of the control unit 32. At least part of the storage unit 34 may be included in the control unit 32.

The information acquiring device 40 may include a sensor for determining, for example, the color or external shape of the inspection target 50. The information acquiring device 40 may include a color sensor for detecting the color of the inspection target 50. The information acquiring device 40 may include a shape measurement sensor, such as a displacement sensor, for detecting the external shape of the inspection target 50. The information acquiring device 40 may include a range sensor for detecting the distance to the inspection target 50. The information acquiring device 40 may, for example, include an image capturing device, such as a camera, that captures an image of the inspection target 50 and an image processing device that analyzes the captured image to determine the color or external shape of the inspection target 50.

The information acquiring device 40 may acquire information associated with the inspection target 50. The information associated with the inspection target 50 may include information regarding, for example, the color or external shape of the inspection target 50. The information acquiring device 40 may include an interface for acquiring information from, for example, an external sensor. In a case where the illuminating system 1 is installed for an inspection process for automobiles, each automobile coming for the inspection process as the inspection target 50 may be identified with, for example, an IC tag that stores information, such as the model, the grade, or the color. The information acquiring device 40 may acquire information about the automobile that is the inspection target 50 from, for example, the IC tag.

The illuminating system 1 may further include a driving device 70 that drives the illuminating device 20. The driving device 70 may move the illuminating device 20 in a translational direction to determine the position of the illuminating device 20. The driving device 70 may rotate the illuminating device 20 about a predetermined axis, which is the center axis, to determine the orientation of the light emitting surface of the light guiding member 22 of the illuminating device 20. The control device 30 can control the position of the illuminating device 20 and the orientation of the light emitting surface of the light guiding member 22 of the illuminating device 20 by controlling the driving device 70.

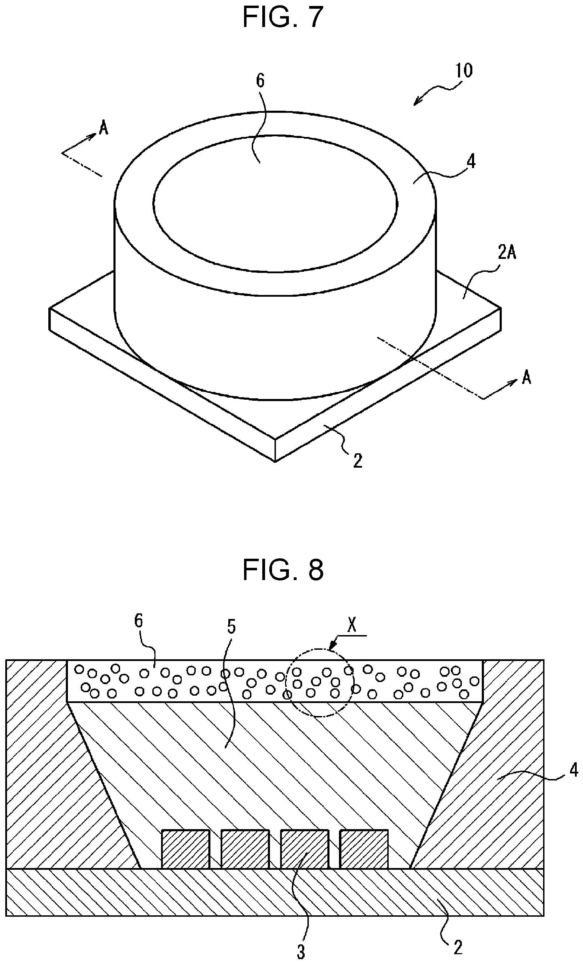

As illustrated in Fig. 7, Fig. 8, and Fig. 9, the light emitting device 10 includes a light emitting element 3 and a wavelength conversion member 6. The light emitting device 10 may further include an element substrate 2, a frame body 4, and a sealing member 5.

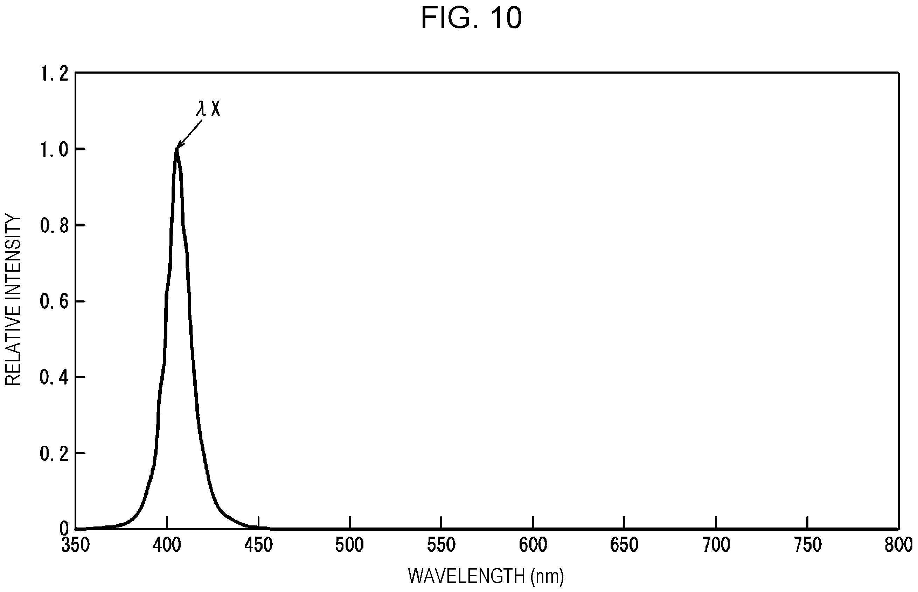

The light emitting element 3 emits light having a peak wavelength in a wavelength range of 360 nm to 430 nm. The light emitting element 3 can emit, for example, light having a spectrum shown as the graph in Fig. 10. In the graph in Fig. 10, the horizontal axis and the vertical axis respectively represent the wavelength and the relative intensity of light emitted by the light emitting element 3. The relative intensity is expressed as the ratio of an intensity to the intensity at the peak wavelength. According to the graph in Fig. 10, the light emitting element 3 emits light having a wavelength indicated by λx as its peak wavelength. The wavelength indicated by λx is included in a wavelength range of 360 nm to 430 nm. That is, the light emitting element 3 emits light having a peak wavelength in a wavelength range of 360 nm to 430 nm. Light having a peak wavelength in a wavelength range of 360 nm to 430 nm is also called violet light. A wavelength range of 360 nm to 430 nm is also called a violet light range.

The wavelength conversion member 6 converts light coming into the wavelength conversion member 6 from the light emitting element 3 to light having a peak wavelength in the visible light range and emits the converted light. It is assumed that visible light includes violet light. It is assumed that the visible light range includes the violet light range.

The light emitting device 10 may include a plurality of wavelength conversion members 6. The plurality of wavelength conversion members 6 may emit light rays having different peak wavelengths respectively. The light emitting device 10 can emit light rays having various spectra by controlling the intensity of a light ray emitted by each wavelength conversion member 6.

The element substrate 2 may be formed of, for example, an insulating material. The element substrate 2 may be formed of, for example, a ceramic material, such as alumina or mullite, a glass ceramic material, or a composite material acquired by mixing a plurality of materials among the above-described materials. The element substrate 2 may be formed of, for example, a polymeric resin material in which metal-oxide particles for which thermal expansion can be adjusted are dispersed.

The element substrate 2 may include, on a main surface 2A of the element substrate 2 or inside the element substrate 2, a wiring conductor that allows electrical conduction of components including the light emitting element 3 mounted on the element substrate 2. The wiring conductor may be formed of, for example, a conductive material, such as tungsten, molybdenum, manganese, or copper. The wiring conductor may be formed by printing, on ceramic green sheets that form the element substrate 2, a predetermined pattern with metal paste made of tungsten powder to which an organic solvent is added and by stacking and firing the plurality of ceramic green sheets. On the surface of the wiring conductor, for example, a plated layer made of, for example, nickel or gold may be formed to prevent oxidation.

The element substrate 2 may include a metal reflection layer spaced apart from the wiring conductor and the plated layer to efficiently release light emitted by the light emitting element 3 to the outside. The metal reflection layer may be formed of, for example, a metal material made of, for example, aluminum, silver, gold, copper, or platinum.

This embodiment assumes that the light emitting element 3 is an LED (light emitting diode). An LED has a PN junction at which a P-type semiconductor and an N-type semiconductor join and at which electrons and positive holes are recoupled to thereby externally emit light. The light emitting element 3 is not limited to an LED and may be another type of light emitting element, such as an LD (laser diode).

The light emitting element 3 is mounted on the main surface 2A of the element substrate 2. The light emitting element 3 may be electrically connected onto the plated layer that adheres to the surface of the wiring conductor provided on or in the element substrate 2 via, for example, a brazing material or solder. The number of light emitting elements 3 mounted on the main surface 2A of the element substrate 2 is not specifically limited.

The light emitting element 3 may include a translucent base substrate and an optical semiconductor layer formed on the translucent base substrate. The translucent base substrate includes, for example, a material that allows deposition of the optical semiconductor layer thereon using chemical vapor deposition, such as metal-organic chemical vapor deposition or molecular beam epitaxial deposition. The translucent base substrate may be made of, for example, sapphire, gallium nitride, aluminum nitride, zinc oxide, zinc selenide, silicon carbide, silicon, or zirconium diboride. The thickness of the translucent base substrate may be, for example, 50 µm or more and 1000 µm or less.

The optical semiconductor layer may include a first semiconductor layer formed on the translucent base substrate, a light emitting layer formed on the first semiconductor layer, and a second semiconductor layer formed on the light emitting layer. The first semiconductor layer, the light emitting layer, and the second semiconductor layer may be formed of, for example, a III-nitride semiconductor, a III-V semiconductor such as gallium phosphide or gallium arsenide, or a III-nitride semiconductor such as gallium nitride, aluminum nitride, or indium nitride.

The thickness of the first semiconductor layer may be, for example, 1 µm or more and 5 µm or less. The thickness of the light emitting layer may be, for example, 25 nm or more and 150 nm or less. The thickness of the second semiconductor layer may be, for example, 50 nm or more and 600 nm or less.

The frame body 4 may be formed of, for example, a ceramic material, such as aluminum oxide, titanium oxide, zirconium oxide, or yttrium oxide. The frame body 4 may be formed of a porous material. The frame body 4 may be formed of a resin material into which powder that contains a metal oxide, such as aluminum oxide, titanium oxide, zirconium oxide, or yttrium oxide, is mixed. The frame body 4 need not be formed of the above-described materials and may be formed of various materials.

The frame body 4 is connected to the main surface 2A of the element substrate 2 via, for example, a resin, a brazing material, or solder. The frame body 4 is provided on the main surface 2A of the element substrate 2 so as to be spaced apart from the light emitting element 3 and surround the light emitting element 3. The frame body 4 is provided such that its inner wall surface is gradually inclined so as to extend outward as its part is farther from the main surface 2A of the element substrate 2. The inner wall surface functions as a reflection surface that reflects light emitted by the light emitting element 3. The inner wall surface may include, for example, a metal layer formed of a metal material, such as tungsten, molybdenum, or manganese, and a plated layer that covers the metal layer and is formed of a metal material, such as nickel or gold. The plated layer reflects light emitted by the light emitting element 3.

The shape of the inner wall surface of the frame body 4 may be a round shape in plan view. When the shape of the inner wall surface is a round shape, the frame body 4 can substantially uniformly reflect light emitted by the light emitting element 3 outward. The angle of inclination of the inner wall surface of the frame body 4 may be set to, for example, an angle of 55 degrees or more and 70 degrees or less relative to the main surface 2A of the element substrate 2.

The inner space surrounded by the element substrate 2 and the frame body 4 is filled with the sealing member 5 except a part of the upper part of the inner space surrounded by the frame body 4. The sealing member 5 seals the light emitting element 3 and allows light emitted by the light emitting element 3 to pass therethrough. The sealing member 5 may be formed of, for example, a material having optical transparency. The sealing member 5 may be formed of, for example, an insulating resin material having optical transparency, such as a silicone resin, an acrylic resin, or an epoxy resin, or a glass material having optical transparency. The refractive index of the sealing member 5 may be set to, for example, 1.4 or more and 1.6 or less.

In a case where the light emitting device 10 includes the sealing member 5, violet light emitted from the light emitting element 3 passes through the sealing member 5 and enters the wavelength conversion member 6. As described above, the wavelength conversion member 6 converts the violet light coming thereinto from the light emitting element 3 to light rays having various peak wavelengths included in the visible light range. The light emitting element 3 is located such that the emitted violet light enters the wavelength conversion member 6. In other words, the wavelength conversion member 6 is located such that light emitted from the light emitting element 3 enters the wavelength conversion member 6. In the structure illustrated in Fig. 7 to Fig. 9, the wavelength conversion member 6 is located in the part of the upper part of the inner space surrounded by the element substrate 2 and the frame body 4 along the upper surface of the sealing member 5. The wavelength conversion member 6 need not be located as in the example described above and may be located so as to, for example, extend out of the upper part of the inner space surrounded by the element substrate 2 and the frame body 4.

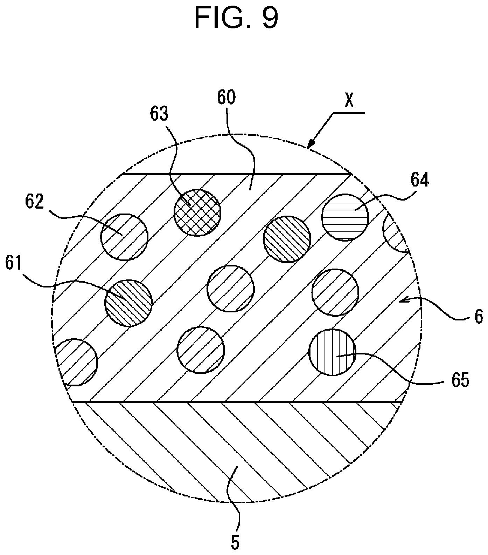

As illustrated in Fig. 9, the wavelength conversion member 6 may include a translucent member 60 having optical transparency, a first fluorescent substance 61, a second fluorescent substance 62, a third fluorescent substance 63, a fourth fluorescent substance 64, and a fifth fluorescent substance 65. The first fluorescent substance 61, the second fluorescent substance 62, the third fluorescent substance 63, the fourth fluorescent substance 64, and the fifth fluorescent substance 65 are also simply called fluorescent substances. It is assumed that the fluorescent substances are contained in the translucent member 60. The fluorescent substances may be substantially uniformly dispersed in the translucent member 60. The fluorescent substances convert violet light entering the wavelength conversion member 6 to light rays having peak wavelengths included in a wavelength range of 360 nm to 780 nm and emits the converted light rays.

The translucent member 60 may be formed of, for example, an insulating resin having optical transparency, such as a fluorine resin, a silicone resin, an acrylic resin, or an epoxy resin, or a glass material having optical transparency.

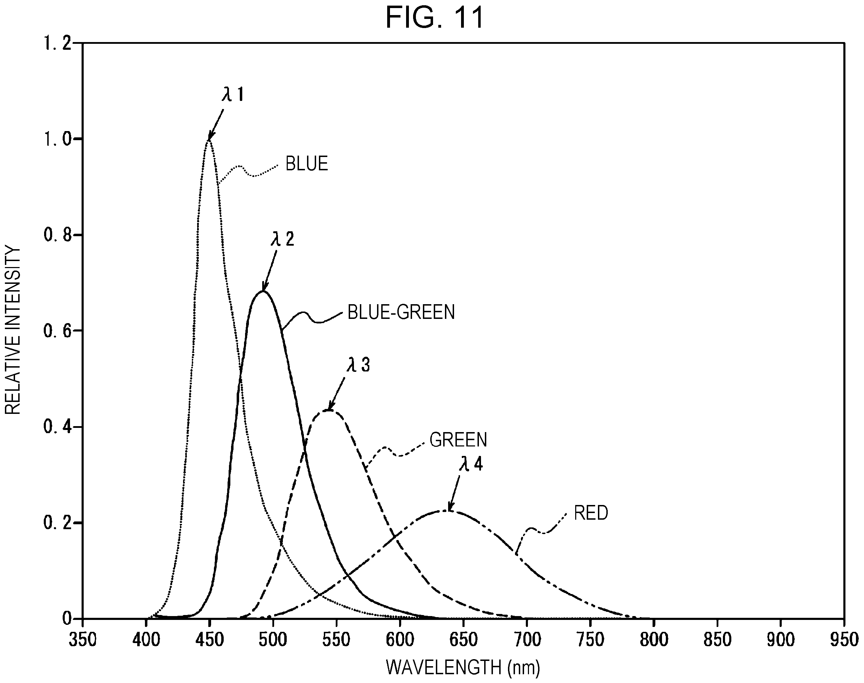

The fluorescent substances convert incoming violet light to light rays having various peak wavelengths. In the graphs in Fig. 11 and Fig. 7, example fluorescence spectra of the fluorescent substances are shown. In the graphs in Fig. 11 and Fig. 7, the horizontal axis and the vertical axis respectively represent the wavelength and the relative intensity of light emitted by each fluorescent substance.

The first fluorescent substance 61 may have a first peak wavelength indicated by λ1 in the graph in Fig. 11. It is assumed that the first peak wavelength is a wavelength within a wavelength range of 400 nm to 500 nm. The first fluorescent substance 61 emits, for example, blue light. As the first fluorescent substance 61, for example, BaMgAl₁₀O₁₇:Eu, or (Sr,Ca,Ba)₁₀(PO₄)₆Cl₂:Eu, (Sr,Ba)₁₀(PO₄)₆Cl₂:Eu can be used.

The second fluorescent substance 62 may have a second peak wavelength indicated by λ2 in the graph in Fig. 11. It is assumed that the second peak wavelength is a wavelength within a wavelength range of 450 nm to 550 nm. The second fluorescent substance 62 emits, for example, blue-green light. As the second fluorescent substance 62, for example, (Sr,Ba,Ca)₅(PO₄)₃Cl:Eu, Sr₄Al₁₄O₂₅:Eu can be used.

The third fluorescent substance 63 may have a third peak wavelength indicated by λ3 in the graph in Fig. 11. It is assumed that the third peak wavelength is a wavelength within a wavelength range of 500 nm to 600 nm. The third fluorescent substance 63 emits, for example, green light. As the third fluorescent substance 63, for example, SrSi₂(O,Cl)₂N₂:Eu, (Sr,Ba,Mg)₂SiO₄:Eu²⁺, or ZnS:Cu,Al, Zn₂SiO₄:Mn can be used.

The fourth fluorescent substance 64 may have a fourth peak wavelength indicated by λ4 in the graph in Fig. 11. It is assumed that the fourth peak wavelength is a wavelength within a wavelength range of 600 nm to 700 nm. The fourth fluorescent substance 64 emits, for example, red light. As the fourth fluorescent substance 64, for example, Y₂O₂S:Eu, Y₂O₃:Eu, SrCaClAlSiN₃:Eu²⁺, CaAlSiN₃:Eu, or CaAlSi(ON)₃:Eu can be used.

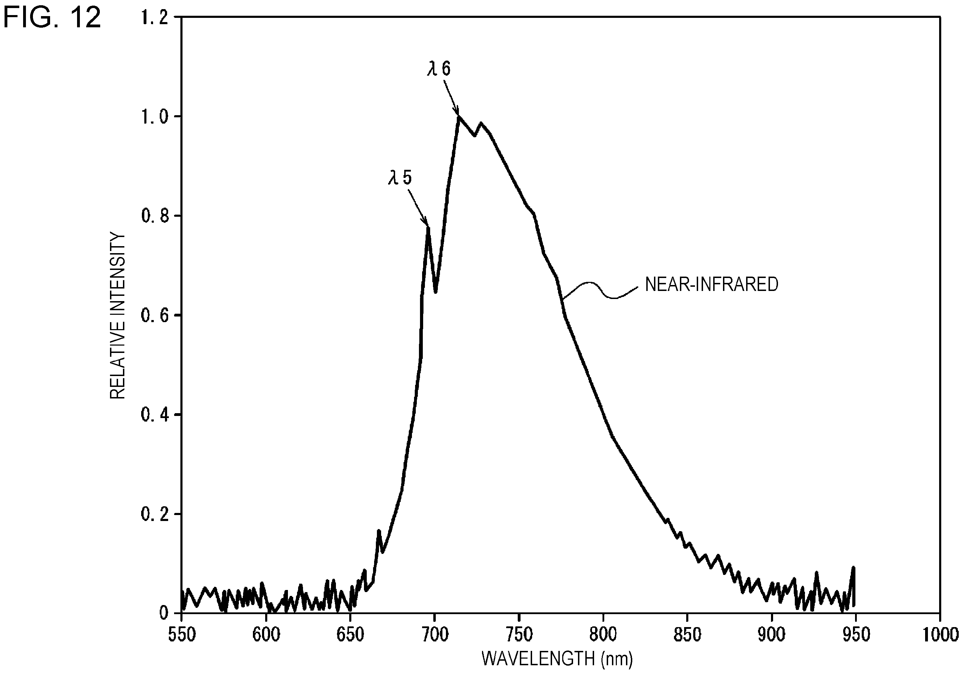

The fifth fluorescent substance 65 may have a fifth peak wavelength indicated by λ5 and a sixth peak wavelength indicated by λ6 in the graph in Fig. 12. It is assumed that the fifth peak wavelength and the sixth peak wavelength are wavelengths within a wavelength range of 680 nm to 800 nm. The fifth fluorescent substance 65 emits, for example, near-infrared light. The near-infrared light may include light in a wavelength range of 680 to 2500 nm. As the fifth fluorescent substance 65, for example, 3Ga₅O₁₂:Cr can be used.

The combination of the types of fluorescent substances contained in the wavelength conversion member 6 is not specifically limited. As indicated by the region X in Fig. 8 and Fig. 9, the wavelength conversion member 6 may have the first fluorescent substance 61, the second fluorescent substance 62, the third fluorescent substance 63, the fourth fluorescent substance 64, and the fifth fluorescent substance 65. The wavelength conversion member 6 may have other types of fluorescent substances.

The light emitting device 10 may include the plurality of wavelength conversion members 6. The wavelength conversion members 6 may have different combinations of fluorescent substances. The light emitting device 10 may include the light emitting element 3 that emits violet light to each wavelength conversion member 6. The light emitting device 10 can emit light rays having various spectra by controlling the intensity of violet light that enters each wavelength conversion member 6.

The light emitting device 10 according to this embodiment includes the wavelength conversion member 6, and therefore, can emit light rays having various spectra. For example, the light emitting device 10 can emit light having, for example, the spectrum of direct sunlight from the sun, the spectrum of sunlight that reaches a predetermined depth under the sea, the spectrum of candle light, or the spectrum of a firefly flash. In other words, the light emitting device 10 can emit light rays in various colors.

The color of light is identified with the spectrum of the light and is also expressed by the color temperature. The color temperature is a parameter associated with the temperature of a black body. The color temperature of the spectrum of light radiated by a black body having a temperature expressed by T is expressed as T. For example, the color temperature of the spectrum of light radiated by a black body of 5000 K (Kelvin) is expressed as 5000 K. The color of light having a color temperature of about 4000 K to 5000 K is also called white. As the color temperature of light is lower than that of white light, the color of the light can include more red components. That is, light having a low color temperature looks reddish. As the color temperature of light is higher than that of white light, the color of the light can include more blue components. That is, light having a high color temperature looks bluish.

Not only the spectrum of light radiated by a black body but also a spectrum analogous to the spectrum of light radiated by a block body may be expressed by a color temperature. It is assumed that in a case where a specific spectrum is analogous to the spectrum of light radiated by a black body having a temperature expressed by T, the color temperature of the specific spectrum is expressed as T. Whether the spectra of two light rays have an analogousness relationship may be determined on the basis of various conditions. The conditions for the spectra of two light rays to have an analogousness relationship may include a condition that, for example, when the relative intensities of two light rays are compared with each other for each wavelength in their spectra, the difference at each wavelength is within a predetermined range. The conditions for the spectra of two light rays to have an analogousness relationship may include a condition that, for example, the difference between the peak wavelengths included in the spectra of two light rays is within a predetermined range. The conditions for the spectra of two light rays to have an analogousness relationship are not limited to the above-described examples and may include various conditions.

For example, the spectrum of sunlight at about noon can be approximated by the spectrum of light radiated by a black body of about 5000 K. In this case, the color temperature of sunlight at about noon is expressed as about 5000 K. The color of light expressed by a color temperature of about 5000 K is also called neutral white. The color of light expressed by a color temperature of about 6500 K higher than the color temperature of neutral white is also called a daylight color. The daylight color includes more blue components than white components and looks bluish.

The color temperature of sunlight at a time point after the elapse of about two hours since sunrise can be expressed as about 4200 K. The color temperature of sunlight at about the time of sunrise or at about the time of sunset can be expressed as about 2000 K. The color temperature of light emitted by an incandescent lamp can be expressed as about 2500 to 2800 K. The color temperature of light emitted by candle light can be expressed as about 2000 K. The color of light expressed by a color temperature of about 2000 to 3000 K is also called an incandescent lamp color.

The light emitting device 10 can emit light having a spectrum expressed by a color temperature and can also emit light having a spectrum not expressible by a color temperature. This embodiment assumes that the control device 30 controls the light emitting device 10 so as to cause the light emitting device 10 to emit light having a spectrum expressed by a color temperature. The control device 30 may control the light emitting device 10 so as to cause the light emitting device 10 to emit light having a spectrum not expressible by a color temperature.

In the illuminating system 1, the inspection target 50 to be visually inspected by the inspector 8 is illuminated by the illuminating device 20 with the first inspection light. It is assumed that in the illuminating system 1, the illuminating devices 20 are disposed such that inspection light forms light-dark illumination. The inspector 8 views the inspection target 50 that reflects the light-dark illumination to thereby inspect the external appearance of the inspection target 50. The inspector 8 can inspect the external appearance of the inspection target 50 on the basis of the appearance of the light-dark illumination reflected on the surface of the inspection target 50. For example, in a case where the inspection target 50 is an automobile, light-dark illumination is reflected on the surface of the body of the automobile as illustrated in Fig. 6. The inspector 8 views the light-dark illumination reflected on the surface of the body of the automobile and inspects the external appearance of the body of the automobile on the basis of the appearance. The inspector 8 can easily find a detection target 52 including an adhering matter, such as waste, or a flaw or deformation including irregularities on the boundary between the light emitting region E and the non-light emitting region B of the light-dark illumination reflected on the surface of the body of the automobile. The inspector 8 can determine, for example, whether the boundary between the light emitting region E and the non-light emitting region B forms a smooth line based on the shape of the surface of the body or whether the boundary is irregular due to the presence of the detection target 52. In a case where the boundary is irregular, the inspector 8 can find that the detection target 52 is present at the position. In a case where the boundary appears to be a smooth line, the inspector 8 can determine that the detection target 52 is not present. The inspector 8 may detect the presence of the detection target 52 in a part in which the amount of light that can be visually checked in the light emitting region E of the light-dark illumination reflected on the surface of the body of the automobile changes.

In a case where the inspector 8 views light-dark illumination reflected on the inspection target 50, the appearance for the inspector 8 changes depending on a relationship between the spectrum of inspection light and the color of the surface of the inspection target 50. The color of the surface of the inspection target 50 may be identified with the reflection spectrum of light on the surface of the inspection target 50. Depending on the relationship between the spectrum of inspection light and the color of the surface of the inspection target 50, the inspector 8 may have difficulty in watching the inspection target 50. For example, in a case where inspection light in neutral white is reflected on the surface of the inspection target 50 in white or a bright color close to white, the inspector 8 has difficulty in distinguishing the color of the surface of the inspection target 50 and the inspection light from each other. As a result, the inspector 8 has difficulty in determining the presence of the detection target 52. In this case, the illuminating system 1 causes the illuminating device 20 to emit light in an incandescent lamp color as inspection light to thereby allow the inspector 8 to easily distinguish the color of the surface of the inspection target 50 and the inspection light from each other.

For example, in a case where inspection light in neutral white is reflected on the surface of the inspection target 50 in black or a dark color close to black, the contrast on the boundary between the light emitting region E and the non-light emitting region B reflected on the surface of the inspection target 50 becomes high. As a result, the inspector 8 can easily determine the presence of the detection target 52. That is, in a case where the color of the surface of the inspection target 50 has a brightness lower than or equal to a predetermined value, the illuminating system 1 may cause the illuminating device 20 to emit light in neutral white as the first inspection light.

Depending on the relationship between the spectrum of inspection light and the color of the surface of the inspection target 50, the inspector 8 may be dazzled or may be likely to feel strain. For example, in a case where inspection light in neutral white is reflected on the inspection target 50 having a surface of a high reflectivity, the inspector 8 is likely to be dazzled by reflection of the inspection light. That is, glare is likely to occur. In this case, the illuminating system 1 can create an environment in which the inspector 8 is less likely to be dazzled or feel, for example, strain by causing the illuminating device 20 to emit light in an incandescent lamp color as the first inspection light.

The control device 30 may control the illuminating device 20 such that the color temperature of the first inspection light has a value within a range of 2000 K to 6500 K. Light having a color temperature that is within a range of 2000 K to 6500 K is light that can be visually recognized by people usually. When the color temperature of the first inspection light has a value within a range of 2000 K to 6500 K, the inspector 8 is less likely to feel difficulties.

The illuminating system 1 according to this embodiment can create an environment in which the inspector 8 can easily inspect the inspection target 50 by controlling the spectrum and intensity of the first inspection light.

The illuminating system 1 acquires information regarding the inspection target 50 by the information acquiring device 40. Information regarding the inspection target 50 is also called inspection target information. The information acquiring device 40 may acquire information regarding the color of the surface of the inspection target 50. The information acquiring device 40 may acquire the reflection spectrum of the surface of the inspection target

50. The information acquiring device 40 may acquire the macroscopic shape of the surface of the inspection target 50. The information acquiring device 40 may acquire the distance from the illuminating device 20 to the inspection target 50.

The illuminating system 1 controls, by the control device 30, the spectrum of inspection light (first inspection light) emitted by the illuminating device 20. The control device 30 acquires inspection target information from the information acquiring device 40 and controls the spectrum of inspection light (first inspection light) emitted by the illuminating device 20 on the basis of the information.

In a case where, for example, the color of the surface of the inspection target 50 is a bright color close to the color of white light, the control device 30 may control the spectrum of inspection light (first inspection light) such that the inspection light (first inspection light) is in an incandescent lamp color. In a case where, for example, the color of the surface of the inspection target 50 is a dark color close to black, the control device 30 may control the spectrum of inspection light (first inspection light) such that the inspection light (first inspection light) is neutral white.

The information acquiring device 40 may acquire a brightness as information regarding the color of the surface of the inspection target 50. In a case where the color of the surface of the inspection target 50 is a color having a brightness higher than or equal to a predetermined value, the control device 30 may control the spectrum of inspection light (first inspection light) such that the inspection light (first inspection light) is in an incandescent lamp color. In a case where the color of the surface of the inspection target 50 is a color having a brightness lower than or equal to the predetermined value, the control device 30 may control the spectrum of inspection light (first inspection light) such that the inspection light (first inspection light) is in a daylight color or neutral white. The predetermined value may be set as appropriate. Different predetermined values may be set in a case of making the color of inspection light (first inspection light) be an incandescent lamp color and in a case of making the color of inspection light (first inspection light) be a daylight color or neutral white.

The control device 30 may control the spectrum of the first inspection light on the basis of the brightness of the color of the surface of the inspection target 50 such that the inspection light (first inspection light) has a specific color temperature. For example, the control device 30 may classify the color of the surface of the inspection target 50 into three levels including black, gray, and white on the basis of the brightness of the color. In a case where the color of the surface of the inspection target 50 is classified as black, the control device 30 may control the spectrum of inspection light (first inspection light) such that the color temperature of the inspection light is equal to 6500 K. In a case where the color of the surface of the inspection target 50 is classified as white, the control device 30 may control the spectrum of inspection light (first inspection light) such that the color temperature of the inspection light is equal to 2000 K. In a case where the color of the surface of the inspection target 50 is classified as gray, the control device 30 may control the spectrum of inspection light such that the color temperature of the inspection light is equal to 3500 K. The relationship between the color of the surface of the inspection target 50 and the color temperature of inspection light (first inspection light) is not limited to the above-described examples and may include various relationships.

In a case where light is emitted with the same intensity, the illuminance of light having a low color temperature is lower than the illuminance of light having a high color temperature. As the control device 30 makes the color temperature of the first inspection light lower, the control device 30 may increase the intensity of the first inspection light. Accordingly, the illuminance of the inspection light is less likely to change. As a result, even when inspection light (first inspection light) changes due to a difference in the inspection target 50, the inspector 8 is less likely to feel difficulties.

The control device 30 may control the spectrum of inspection light (first inspection light) on the basis of the hue of the color of the surface of the inspection target 50. In this case, the control device 30 may control the light emitting device 10 to cause the light emitting device 10 to emit light (second inspection light) having a spectrum not expressible by a color temperature. For example, in a case where the color of the surface of the inspection target 50 includes more red components, the control device 30 may control the spectrum of inspection light (first inspection light) such that the inspection light (first inspection light) includes fewer components in green that is a complementary color of red. For example, the control device 30 may control the spectrum of inspection light (first inspection light) such that the inspection light (first inspection light) includes many components in a color similar to the color of the surface of the inspection target 50. Accordingly, the contrast between the light emitting region E and the non-light emitting region B of light-dark illumination reflected on the surface of the inspection target 50 becomes high. As a result, the inspector 8 can easily find an external appearance defect.

The inspector 8 may inspect the color shade of the surface as the external appearance of the inspection target 50. Perception of the color shade of the surface by the inspector 8 differs depending on the inspector 8 and changes on the basis of the spectrum of inspection light. The control device 30 may control the spectrum of inspection light (first inspection light) such that the difference in perception of the color shade of the surface of the inspection target 50 by each inspector 8 becomes smaller. The inspector 8 may inspect the color shade of the surface of the inspection target 50 in the light emitting region E of light-dark illumination reflected on the surface of the inspection target 50.

To inspect the color shade of the inspection target 50 in light in various environments, the control device 30 may cause the illuminating device 20 to reproduce light in various environments as inspection light (first inspection light). The control device 30 can cause the illuminating device 20 to reproduce light in various environments on the basis of information for identifying the spectrum of the light in various environments. For example, in a case where automobiles are sold at various locations around the world, the control device 30 may cause the illuminating device 20 to reproduce sunlight at various locations as the first inspection light so as to allow the inspector 8 to check perception of the color shade of the body in sunlight at various locations. Accordingly, perception of the color shade in the environments at the sites can be checked without moving the inspection target 50 to the sites. As a result, inspection costs can be reduced.

There may be a case where the inspector 8 can easily find a specific external appearance defect by illuminating the inspection target 50 with the first inspection light having a specific spectrum. The control device 30 may cause the illuminating device 20 to emit the first inspection light having the specific spectrum. The specific spectrum may be associated with inspection target information. In a case where the specific spectrum is associated with the inspection target 50, the control device 30 may cause the illuminating device 20 to reproduce light having the specific spectrum on the basis of the inspection target information.

In a case where the inspection target 50 is used in a specific environment, the color shade needs to be inspected in light with which the specific environment is illuminated. Inspection target information may include information regarding the environment in which the inspection target 50 is used. The control device 30 may cause the illuminating device 20 to reproduce the light with which the environment is illuminated on the basis of the information regarding the environment in which the inspection target 50 is used. The inspection target information may include information regarding the shipment destination of the inspection target 50.

In the illuminating system 1, the control device 30 may control the spectrum of the first inspection light on the basis of a database in which pieces of inspection target information and spectra are associated with each other. The control device 30 may store the database in the storage unit 34. The control device 30 may extract a spectrum associated with a piece of inspection target information from the database and cause the illuminating device 20 to emit the first inspection light based on the extracted spectrum.

In the database, as inspection target information, for example, information regarding the color of the surface of the inspection target 50 or the external shape of the inspection target 50 may be associated with a spectrum. As inspection target information, the distance from the illuminating device 20 to the inspection target 50 may be associated with a spectrum. As inspection target information, information regarding an environment in which the inspection target 50 is used or information regarding the shipment destination of the inspection target 50 may be associated with a spectrum.

When the database in which pieces of inspection target information and spectra are associated with each other is prepared in advance, the spectrum of the first inspection light can be easily controlled on the basis of inspection target information.

The light emitting device 10 according to this embodiment excites the fluorescent substances with violet light and converts the violet light to light rays in a plurality of colors to thereby emit light rays having various spectra. A device according to a comparative example excites a fluorescent substance with blue light identified with a spectrum having a peak wavelength in a range of 450 nm to 470 nm. The device according to the comparative example converts, with the fluorescent substance, blue light to yellow light identified with a spectrum having a peak wavelength in a range of 570 nm to 590 nm to thereby emit light analogous to white light. In a case where the inspector 8 views inspection light reflected by the inspection target 50 or the inspection light itself for a long time, blue light components included in the inspection light may affect the retina to a larger degree than violet light components. In a case where the illuminating device 20 including the light emitting device 10 according to this embodiment and the illuminating system 1 illuminate the inspection target 50, the effect on the retina of the inspector 8 can be reduced.

The illuminating device 20 according to one embodiment may include a plurality of light emitting devices 10. The control device 30 may control the spectra of light rays emitted by the respective light emitting devices 10 independently of each other. The control device 30 may control the spectra of light rays emitted by the respective light emitting devices 10 in association with each other. The control device 30 may control the spectra of light rays emitted by the respective light emitting devices 10 in association with each other to thereby control the spectrum of light acquired by combining the light rays emitted by the respective light emitting devices 10. The light acquired by combining the light rays emitted by the respective light emitting devices 10 is also called combined light. The illuminating device 20 may emit the combined light as at least part of the first inspection light.

The light emitting device 10 may include a first light emitting device and a second light emitting device. The control device 30 may control the spectrum of light emitted by the first light emitting device and the intensity and spectrum of light emitted by the second light emitting device independently of each other or in association with each other. The control device 30 may control the spectrum of combined light acquired by combining light emitted by the first light emitting device and light emitted by the second light emitting device. The spectrum and intensity of light emitted by the first light emitting device may be different from the spectrum and intensity of light emitted by the second light emitting device. The control device 30 may control the spectrum of combined light, at least part of which is included in inspection light (first inspection light), on the basis of inspection target information.

Each light emitting device 10 may emit light having a peak wavelength in a wavelength range of 360 nm to 430 nm and may emit light having a peak wavelength in a wavelength range of 360 nm to 780 nm. Each light emitting device 10 may emit light having a peak wavelength in a wavelength range of 360 nm to 780 nm such that combined light has a peak wavelength in a wavelength range of 360 nm to 780 nm.

Depending on the incidence angle of inspection light, the surface of the inspection target 50 that reflects the inspection light looks different. In a system according to a comparative example, it is assumed that the illuminating device 20 does not move. In the comparative example, when the inspector 8 themselves moves, the inspector 8 can change the incidence angle of inspection light (first inspection light). In the illuminating system 1 according to this embodiment, the control device 30 may control the incidence angle of inspection light (first inspection light) relative to the inspection target 50 by controlling the driving device 70 on the basis of information regarding the external shape of the inspection target 50. Accordingly, even when the inspector 8 does not move, the state of incidence of inspection light (first inspection light) is changed such that the inspector 8 can easily perform an inspection. As a result, the accuracy of an external appearance inspection by the inspector 8 increases.

Depending on the distance from the light emitting surface, through which inspection light is emitted, to the surface of the inspection target 50, the surface of the inspection target 50 that reflects the inspection light looks different. In a system according to a comparative example, the inspection target 50 moves along a specific course. On the other hand, the illuminating device 20 does not move. That is, in the system according to the comparative example, it is not possible to change the distance from the light emitting surface to the inspection target 50 as desired. In the illuminating system 1 according to this embodiment, the control device 30 may control the driving device 70 on the basis of the distance from the illuminating device 20 to the inspection target 50 to thereby move the position of the illuminating device 20 and control the distance from the illuminating device 20 to the inspection target 50. Accordingly, the state of incidence of inspection light (first inspection light) is changed such that the inspector 8 can easily perform an inspection. As a result, the accuracy of an external appearance inspection by the inspector 8 increases.

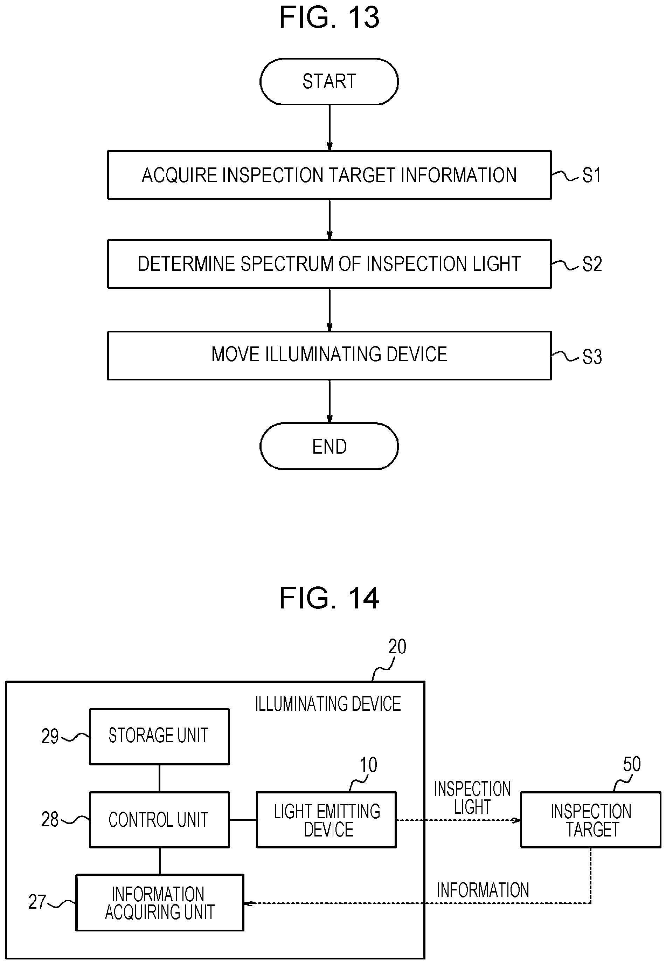

The illuminating system 1 may control the first inspection light in accordance with the procedure illustrated by the flowchart in Fig. 13.

The control device 30 acquires inspection target information (step S1).

The control device 30 determines the spectrum of the first inspection light to be emitted by the illuminating device 20 on the basis of the inspection target information (step S2). The control device 30 may determine the spectrum of the first inspection light on the basis of the color of the surface of the inspection target 50.

The control device 30 causes the driving device 70 to move the illuminating device 20 on the basis of the inspection target information (step S3). The control device 30 may move the illuminating device 20 on the basis of the external shape of the inspection target 50. The control device 30 may move the illuminating device 20 on the basis of the distance from the illuminating device 20 to the inspection target 50. In a case where the inspection target 50 is automatically conveyed for an inspection process, the control device 30 may move the illuminating device 20 in accordance with the conveyance operation for the inspection target 50.

After the control device 30 performs the procedure in step S3, the flowchart in Fig. 13 may end.

The illuminating system 1 according to this embodiment can increase the accuracy of an external appearance inspection by the inspector 8 by controlling the illuminating device 20 on the basis of inspection target information. The illuminating system 1 controls the spectrum of the first inspection light on the basis of the color of the surface of the inspection target 50 to thereby facilitate detection of an external appearance defect in the inspection target 50 by the inspector 8. The illuminating system 1 moves the illuminating device 20 on the basis of the external shape of the inspection target 50 to thereby facilitate detection of an external appearance defect in the inspection target 50 by the inspector 8. The illuminating system 1 moves the illuminating device 20 on the basis of the distance from the illuminating device 20 to the inspection target 50 to thereby facilitate detection of an external appearance defect in the inspection target 50 by the inspector 8.

The illuminating device 20 according to another embodiment illustrated in Fig. 14 may include the light emitting device 10 and a control unit 28. The illuminating device 20 may further include a storage unit 29. The control unit 28 and the storage unit 29 may have configurations the same as or similar to those of the control unit 32 and the storage unit 34 of the control device 30 illustrated in Fig. 1 respectively.

The illuminating device 20 may further include an information acquiring unit 27. In a case where the illuminating device 20 includes the information acquiring unit 27, the illuminating device 20 acquires inspection target information by the information acquiring unit 27. In a case where the illuminating device 20 does not include the information acquiring unit 27, the illuminating device 20 may acquire inspection target information from an external device via an interface of the control unit 28. The information acquiring unit 27 may have a configuration the same as or similar to that of the information acquiring device 40 illustrated in Fig. 1.

When the illuminating device 20 includes the control unit 28, the illuminating device 20 can control the spectrum of the first inspection light by itself. Accordingly, a configuration for controlling the spectrum of the first inspection light can be easily installed.

The diagrams for describing the embodiments of the present disclosure are schematic diagrams. For example, the dimensions and ratios in the drawings do not necessary correspond to the actual dimensions or ratios.

Although the embodiments of the present disclosure have been described with reference to the drawings and examples, it should be understood that a person skilled in the art can easily make various modifications or corrections on the basis of the present disclosure. Therefore, it should be noted that such modifications or corrections are included in the scope of the present disclosure. For example, functions included in, for example, constituent units can be reconfigured so as not to cause any logical contradiction and, for example, a plurality of constituent units can be combined to form one constituent unit or one constituent unit can be divided.

In the present disclosure, the expressions of, for example "first" and "second" are identifiers for distinguishing the constituent elements from each other. For constituent elements distinguished from each other by the expressions of, for example, "first" and "second" in the present disclosure, the numbers given to the constituent elements can be exchanged. For example, for the first light emitting device, its identifier "first" can be exchanged with "second" that is the identifier of the second light emitting device. Identifiers are exchanged simultaneously. Even after the exchange of identifiers, the constituent elements are distinguished from each other. An identifier may be removed. A constituent element from which its identifier is removed is distinguished with a reference numeral. The expressions of identifiers, such as "first" and "second", in the present disclosure should not be used to interpret the order of the constituent elements or form a basis that an identifier of a smaller number is present. Reference Signs List

1 illuminating system
8 inspector
10 light emitting device (2: element substrate, 2A: main surface, 3: light emitting element, 4: frame body, 5: sealing member, 6: wavelength conversion member, 60: translucent member, 61 to 65: first to fifth fluorescent substances)
20 illuminating device (27: information acquiring unit, 28: control unit, 29: storage unit)
30 control device (32: control unit, 34: storage unit)
40 information acquiring device
50 inspection target
70 driving device

## Claims

1. An illuminating system comprising:
an illuminating device that emits first inspection light with which an inspection target is illuminated;
an information acquiring device that acquires information regarding the inspection target; and
a control device that controls the first inspection light on the basis of the information regarding the inspection target.

2. The illuminating system according to Claim 1, wherein the information regarding the inspection target is information regarding a color of a surface of the inspection target.

3. The illuminating system according to Claim 1 or 2,
wherein the information acquiring device includes a color sensor for detecting a color of a surface of the inspection target.

4. The illuminating system according to Claim 1, wherein the information regarding the inspection target is information about a reflection spectrum on a surface of the inspection target.

5. The illuminating system according to any one of Claims 1 to 4, wherein the control device controls a spectrum of the first inspection light.

6. The illuminating system according to any one of Claims 1 to 5, wherein the control device controls a color temperature of the first inspection light.

7. The illuminating system according to any one of Claims 1 to 6, wherein
the illuminating device includes a light emitting device that emits second inspection light, a light guiding member that has a light emitting surface through which the second inspection light is emitted as third inspection light, and a peripheral part that is located on an outside of the light emitting surface and reduces the third inspection light, and
the light guiding member transmits light entering from the light emitting device along the light emitting surface and emits the light in a direction crossing the light emitting surface as the first inspection light.

8. The illuminating system according to Claim 7, wherein
the light emitting device includes a first light emitting device and a second light emitting device, and
the illuminating device emits light acquired by combining light emitted by the first light emitting device and light emitted by the second light emitting device as the first inspection light.

9. The illuminating system according to Claim 7 or 8, wherein
the light emitting device includes
a light emitting element that emits light having a peak wavelength in a wavelength range of 360 nm to 430 nm, and
a wavelength conversion member that converts the light emitted by the light emitting element to light having a peak wavelength in a wavelength range of 360 nm to 780 nm.

10. The illuminating system according to Claim 9, wherein
the wavelength conversion member includes
a fluorescent substance that includes at least one of a first fluorescent substance having a first peak wavelength in a wavelength range of 400 nm to 500 nm, a second fluorescent substance having a second peak wavelength in a wavelength range of 450 nm to 550 nm, a third fluorescent substance having a third peak wavelength in a wavelength range of 500 nm to 600 nm, a fourth fluorescent substance having a fourth peak wavelength in a wavelength range of 600 nm to 700 nm, or a fifth fluorescent substance having a fifth peak wavelength and a sixth peak wavelength in a wavelength range of 680 nm to 800 nm.

11. The illuminating system according to any one of Claims 1 to 10, wherein the control device controls a color temperature of the first inspection light so as to be within a range of 2000 K to 6500 K.

12. The illuminating system according to any one of Claims 1 to 11, further comprising
a driving device that moves the illuminating device, wherein
the control device controls the driving device on the basis of the information regarding the inspection target.

13. An illuminating device comprising:
a light emitting device that emits second inspection light included in first inspection light with which an inspection target is illuminated;
an information acquiring unit that acquires information regarding the inspection target; and
a control unit that controls the first inspection light on the basis of the information regarding the inspection target.

14. The illuminating device according to Claim 13, wherein the information acquiring unit includes a color sensor for detecting a color of a surface of the inspection target.

15. The illuminating device according to Claim 13 or 14, further comprising:
a light guiding member that has a light emitting surface through which the second inspection light entering from the light emitting device is emitted as third inspection light; and
a peripheral part that is located on an outside of the light emitting surface and reduces the third inspection light, wherein
the light guiding member transmits light entering from the light emitting device along the light emitting surface and emits the light in a direction crossing the light emitting surface as the first inspection light.

16. The illuminating device according to any one of Claims 13 to 15, wherein the light emitting device includes a first light emitting device and a second light emitting device, and the illuminating device emits light acquired by combining light emitted by the first light emitting device and light emitted by the second light emitting device as at least part of the first inspection light.

17. The illuminating device according to any one of Claims 13 to 16, wherein
the light emitting device includes
a light emitting element that emits light having a peak wavelength in a wavelength range of 360 nm to 430 nm, and
a wavelength conversion member that converts the light emitted by the light emitting element to light having a peak wavelength in a wavelength range of 360 nm to 780 nm.

18. The illuminating device according to Claim 17, wherein
the wavelength conversion member includes
a fluorescent substance that includes at least one of a first fluorescent substance having a first peak wavelength in a wavelength range of 400 nm to 500 nm, a second fluorescent substance having a second peak wavelength in a wavelength range of 450 nm to 550 nm, a third fluorescent substance having a third peak wavelength in a wavelength range of 500 nm to 600 nm, a fourth fluorescent substance having a fourth peak wavelength in a wavelength range of 600 nm to 700 nm, or a fifth fluorescent substance having a fifth peak wavelength and a sixth peak wavelength in a wavelength range of 680 nm to 800 nm.

19. The illuminating device according to any one of Claims 13 to 18, wherein the control unit controls a color temperature of the first inspection light so as to be within a range of 2000 K to 6500 K.

20. An illumination control method comprising:
an emitting step of emitting first inspection light with which an inspection target is illuminated;
an information acquiring step of acquiring information regarding the inspection target; and
a control step of controlling the first inspection light on the basis of the information regarding the inspection target.
